# EUROPEAN PATENT SPECIFICATION

(11) **EP 1 246 359 B1**
(45) Date of publication and mention of the grant of the patent: **22.12.2010**
(21) Application number: 02290727.3
(22) Date of filing: 22.03.2002
(51) Int. Cl.: H03H 9/64, H03H 9/00, H03H 9/145, H03H 9/25

(54) **Surface acoustic wave filter, surface acoustic wave device using the filter, and communications device using the filter or the device**
Akustisches Oberflächenwellenfilter, dasselbe gebrauchende akustische Oberflächenwellenvorrichtung und Kommunikationsanordnung unter Gebrauch des Filters oder der Vorrichtung
Filtre à ondes acoustiques de surface, dispositif à ondes acoustiques de surface employant le filtre et appareil de communication employant le filtre ou le dispositif

(30) Priority: 23.03.2001 JP 2001084856; 20.08.2001 JP 2001249405
(43) Date of publication of application: 02.10.2002
(73) Proprietor: MURATA MANUFACTURING CO., LTD., Nagaokakyo-shi, Kyoto 617-8555 (JP)
(72) Inventor: Takamine, Yuichi c/o (A170) Intel. Prop. Dept., Kyoto-fu 617-8555 (JP)
(74) Representative: Orian, Yvette Suzanne

(56) References cited:
- EP-A- 1 152 529
- EP-A- 1 158 672
- EP-A- 1 237 275
- WO-A-00/25423
- WO-A-98/52281
- JP-A- 5 145 367

## Description

### Background Of The Invention

### 1. Field of the Invention

The present invention relates to a longitudinal coupling resonator type surface acoustic wave filter, a surface acoustic wave device using the filter, and a communications device using the filter or device.

In recent years, the number of subscribers to communications devices such as portable telephones and the like has increased, and the services of the communications devices have been more diversified. For this reason, communications devices of which the transmission-side frequency band and the reception-side frequency band are set near to each other have been increased in number. Moreover, it is needed to provide a desired amount of attenuation in the extreme vicinity of a pass band, depending on the types of communications devices so that interference between the communications devices and other communications devices can be prevented. For surface acoustic wave filters widely used as band-pass filters in the RF stages of portable telephones, it has been more intensively required to provide a desired amount of attenuation in the vicinity of a pass band.

Moreover, for the purpose of reducing the number of parts contained in such a surface acoustic wave filter, it has been more demanded to provide a balanced-unbalanced signal conversion function, a so-called balum function, for the surface acoustic wave filter. For this reason, the use of longitudinal coupling resonator type surface acoustic wave filters as band pass filters in the RF stages of portable telephones has become mainstream, since the filters can easily correspond to the balanced-unbalanced signal conversion function. For example, Japanese Unexamined Patent Application Publication No. 5-267990 discloses such a longitudinal coupling resonator type surface acoustic wave filter.

In the above-described longitudinal coupling resonator type surface acoustic wave filters of the related art, disadvantageously, deterioration of a "shoulder"-characteristic (the reduction in steepness of a frequency characteristic), called transversal response is caused on the higher frequency side of a pass band. Therefore, there are problems in that attenuation on the higher frequency side of the pass band cannot be set to be satisfactory, although it is required by communications devices which operate in a PCS system (Personal Communication System) or the like. As a filter having a large amount of attenuation on the higher frequency side of a pass band, for example, Japanese Unexamined Patent Application Publication No. 10-126212 discloses a ladder type surface acoustic wave device. However, it is problematic that the balanced-unbalanced conversion function can not be attained by ladder type surface acoustic wave filters. That is, according to the related art, it has been difficult to produce a surface acoustic wave device having a sufficient amount of attenuation on the higher frequency side of the pass band and also having a balanced-unbalanced conversion function.

WO00/25423 describes a longitudinal coupling resonator type surface acoustic wave filter including at least two interdigital transducers in which, in the region where two IDTs are adjacent to each other, the electrode finger pitch in each IDT reduces, in a continuous manner, towards the end of the IDT. The pre-characterising portion of claim 1 Is based on WO00/25423.

JP 05-145367 describes a longitudinal coupling resonator type surface acoustic wave filter including at least two interdigital transducers in which the IDTs may be subjected to withdrawal weighting. This results in IDTs which have, disposed at multiple locations along the IDT, pairs of adjacent electrode fingers of the same polarity.

WO98/57429 describes a surface wave device which incorporates a number of single phase unidirectional transducers and reflection gratings. Once again, the transducers may be subjected to withdrawal weighting, resulting in single phase unidirectional transducers have pairs of adjacent electrode fingers of the same polarity disposed at multiple locations along the transducers.

The applicant's own European patent applications EP-A-1,152,529, EP-A-1,237,275 and EP-A-1,158,672 - having priority dates before the priority date of the present application but published afterwards - all describe longitudinal coupling resonator type surface acoustic wave filters including plural interdigital transducers having narrow pitch electrode finger portions in which there are adjacent electrode fingers having the same polarity. EP-A-1,152,529 describes an embodiment in which there are plural pairs of adjacent electrode fingers having the same polarity in the narrow pitch electrode finger portions. EP-A-1,237,275 and EP-A-1,158,672 describe embodiments in which a pair of adjacent electrode fingers having the same polarity are provided at one end of the narrow pitch electrode finger portion.

### Summary Of The Invention

Accordingly, it is an object of the present invention to solve the above-described problems and to provide a longitudinal coupling resonator type surface acoustic wave filter of which the transversal response can be considerably reduced compared with a surface acoustic wave filter of the related art and with which a balanced-unbalanced signal conversion function can be provided.

To attain the above-described object, according to the present invention, there is provided a longitudinal coupling resonator type surface acoustic wave filter comprising a piezoelectric substrate, and at least two interdigital transducers arranged on the piezoelectric substrate along the direction in which a surface acoustic wave is propagated, at least one of the interdigital transducers being provided with a small pitch electrode finger portion in the end thereof which is adjacent to the other interdigital transducer, the small pitch electrode finger portion having electrode fingers of which the pitch is smaller than that of the other electrode fingers in said at least one interdigital transducer, characterized in that the small pitch electrode finger portion includes, at a position substantially at the centre thereof, two adjacent electrode fingers which are electrode-inverted such that the polarities of the two adjacent electrode fingers are made the same; and there are not more than two such adjacent electrode fingers in the same small pitch electrode finger portion.

Also, preferably, the electrode-inversion is carried out symmetrically with respect to the center of the surface acoustic wave filter.

Preferably, the polarities of the adjacent electrode fingers contained in the adjacent interdigital transducers, respectively, are made different from each other.

Moreover, according to the present invention, there is provided a surface acoustic wave device having a balanced-unbalanced conversion function which includes the above-described longitudinal coupling resonator type surface acoustic wave filter.

Furthermore, according to the present invention, there is provided a communications device which includes the above-described longitudinal coupling resonator type surface acoustic wave filter or above-described surface acoustic wave device of the present invention.

The surface acoustic wave filter of the present invention is advantageous in that the transversal response is reduced, since two adjacent electrode fingers in the small pitch electrode finger portion are electrode-inverted, that is, the polarities of the adjacent electrode fingers are made the same. Moreover, the longitudinal coupling resonator type surface acoustic wave filter is advantageous in that the pass band width can be made large, and the transversal response can be reduced, since preferably the position where the electrode-inversion is carried out is substantially the center of the small pitch electrode finger portion.

Furthermore, advantageously, in the longitudinal coupling resonator type surface acoustic wave filter, a ripple can be eliminated from the pass band, and the transversal response can be reduced, since the electrode inversion is preferably carried out symmetrically with respect to the center of the surface acoustic wave filter.

In addition, the transversal response can be reduced in a still wider range, since the polarities of the adjacent electrode fingers contained in the neighboring interdigital transducers, respectively, are preferably made different from each other.

The surface acoustic wave filter having a balanced-unbalanced conversion function according to the present invention is advantageous in that the amount of attenuation on the higher frequency side of the pass band is improved, since the device includes the surface acoustic wave filter of the present invention.

The communications device of the present invention is advantageous in that the communication qualities are superior and the reliability is high, since the device includes the longitudinal coupling resonator type surface acoustic wave filter or surface acoustic wave device of the present invention.

The above and other features and advantages of the present invention will become apparent from reading the following description of preferred embodiments thereof, given by way of example, with reference to the accompanying drawings.

### Brief Description Of The Drawings

Fig. 1 is a schematic plan view showing the configuration of a first embodiment of the present invention;
Fig. 2 is a graph showing the frequency characteristic given by the first embodiment of the present invention which has the configuration shown in Fig. 1;
Fig. 3 is a schematic plan view showing the configuration of an example according to the related art; -
Fig. 4 is a graph showing the frequency characteristic given by the example of the related art which has the configuration shown in Fig. 3;
Fig. 5 is a graph showing the frequency characteristic given, on its own, by the longitudinal coupling resonator type surface acoustic wave filter according to the first embodiment of the present invention;
Fig. 6 is a graph showing the frequency characteristic given, on its own, by the longitudinal coupling resonator type surface acoustic wave filter according to the related art example;
Fig. 7 is a graph showing the frequency characteristic given by the first embodiment of the present invention having the same configuration as shown in Fig. 1 except that the positions for the electrode-inversion are changed to be on the inner side;
Fig..8 is a graph showing the frequency characteristic given by the first embodiment of the present invention having the same configuration as shown in Fig. 1 except that the positions for the electrode-inversion are changed to be on the outer side;
Fig. 9 is a schematic plan view of the first embodiment of the present invention having a configuration different from that shown in Fig. 1;
Fig. 10 is a schematic plan view showing the configuration of a second embodiment of the present invention;
Fig. 11 is a graph showing the frequency characteristic given by the second embodiment of the present invention which has the configuration shown in Fig. 10;
Fig. 12 is a graph showing the frequency characteristic given, on its own, by the longitudinal coupling resonator type surface acoustic wave filter according to the second embodiment of the present invention;
Fig. 13 is a schematic plan view of a third embodiment of the present invention;
Fig. 14 is a block diagram of a communications device using a longitudinal coupling resonator type surface acoustic wave filter or surface acoustic wave device according to the present invention.

### Description Of The Preferred Embodiments

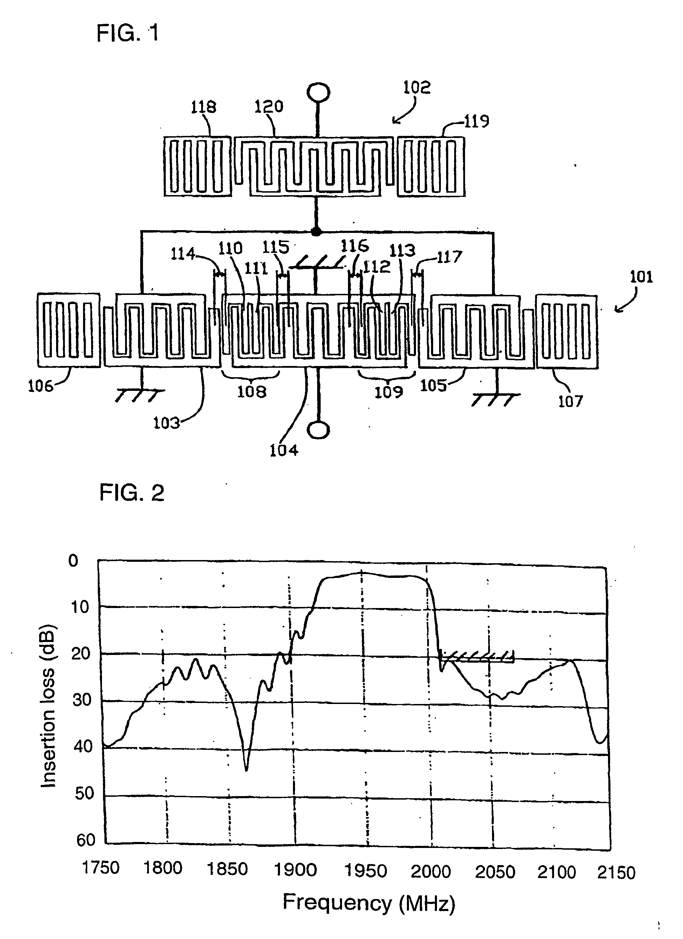

Hereinafter, the longitudinal coupling resonator type surface acoustic wave filter and the surface acoustic wave device according to the present invention will be described with reference to Figs. 1 to 13.

Fig. 1 is a schematic plan view showing the configuration of a first embodiment of the present invention. In all of the embodiments of the present invention, filters for PCS-Rx are described by way of an example.

In the configuration of the first embodiment of the present invention shown in Fig. 1, a longitudinal coupling resonator type surface acoustic wave filter 101 and a surface acoustic wave resonator 102 are formed on a substrate made of 40±5° Y-cut X-propagation LiTaO₃ using Al electrodes. In this embodiment, the surface acoustic wave resonator 102 is connected in series with the longitudinal coupling resonator type surface acoustic wave filter 101. The longitudinal coupling resonator type surface acoustic wave filter 101 comprises IDTs 103, 104, and 105, and two reflectors 106 and 107 arranged so as to sandwich the IDTs 103, 104, and 105. A plurality of electrode fingers connected to the ground and a plurality of electrode fingers connected to a signal line are arranged so as to be opposed to each other in each of the IDTs 103, 104, and 105. The surface acoustic wave resonator 102 comprises IDT 120 and two reflectors 118 and 119 arranged so as to sandwich the IDT 120. In the IDT 120, a plurality of electrode fingers connected to a signal line and a plurality of electrode fingers connected to the IDTs 103 and 105 are arranged so as to be opposed to each other. It should be noted that in Fig. 1, the number of electrode fingers is reduced for simplification.

As shown in Fig. 1, small pitch electrode finger portions 108 and 109 are formed in the longitudinal coupling resonator type surface acoustic wave filter 101. Several electrode fingers of the IDT 104 adjacent to the IDT 103 and several electrode fingers of the IDT 104 adjacent to the IDT 105 having a smaller pitch compared with the pitch of the electrode fingers remaining in the IDT 104 are arranged in the small pitch electrode finger portions 108 and 109, respectively. The polarities of electrode fingers 110 and 111 adjacent to each other in the small pitch electrode finger portion 108, and also, those of electrode fingers 112 and 113 adjacent to each other in the small pitch electrode finger portion 109 are made the same, respectively. That is, the electrodes are inverted. Specifically, for example, the polarity of the electrode fingers connected to the ground is expressed as minus (-), while the polarity of the electrodes connected to the signal line is expressed as plus (+). The array of the polarities (-, +) is represented by + 1, the array of the polarities (+, -) is denoted by -1, and the array of the polarities (-, -) or (+, +) by 0. Then, the polarities of the electrode fingers in the small pitch electrode finger portion 108 shown in Fig. 1 are arranged in the order from the left-side end of +1, -1, 0, +1, -1. Those of the electrode fingers in the small pitch electrode finger portion 109 are arranged in the order from the left-side end of +1, -1, 0, +1, -1. That is, the electrode inversion is carried out symmetrically with respect to the center of the longitudinal coupling resonator type surface acoustic wave filter 101. Even if the electrode inversion is carried out unsymmetrically with respect to the center of the filter 101, it is effective in reducing the transversal response according to the present invention. However, a ripple is generated in the pass band. Thus, such a symmetric configuration as in this embodiment is desirable.

The details of the design of the longitudinal coupling resonator type surface acoustic wave filter 101 are as follows. In the details, the wavelength determined by the pitch of the small pitch electrode fingers is designated by λI2, and that determined by the remaining electrode fingers is denoted by λI1.
the meshing-width W: 73.9 λI1
the number of electrode fingers in the IDT 103: 17
the number of electrode fingers in the IDT 104: 45 (of the electrode fingers, the pitch of the six electrode fingers arranged from each of the right- and left-side ends is decreased)
the number of electrode fingers in the IDT 105: 17
the wavelength λI1 determined by the IDTs: 2.03 µm
the wavelength λI2: 1.85 µm
the wavelength λR determined by the reflectors: 2.06 µm
the number of electrode fingers in the reflectors: 100
the intervals (114, 117) between the IDTs 103 and 104 and the IDTs 104 and 105 : 0.25 λI1 + 0.25 λI2
the intervals (115, 116) between the electrodes adjacent to each other determining the wavelengths λI1 and λI2 in the IDT 104: 0.25 λI1 + 0.25 λI2
the intervals between the IDTs 103, 105 and the reflectors 106, 107: 0.48 λR
the duty ratio of the IDTs: 0.60
the duty ratio of the reflectors: 0.60
the film-thickness of the electrodes: 0.08 λ

Moreover, the details of the design of the surface acoustic wave resonator 102 are as follows.
the meshing-width W: 49.1 λ
the number of electrode fingers in the IDT 120: 401
the wavelength λ (for the IDT 120 and the reflectors 118 and 119): 2.03 µm
the number of electrode fingers in the reflectors 118 and 119: 30
the intervals between the IDT 120 and the reflectors 118 and 119: 0.50 λ
the duty ratio of the IDT120: 0.60
the duty ratio of the reflectors 118 and 119: 0.60
the film-thickness of the electrodes: 0.08 λ

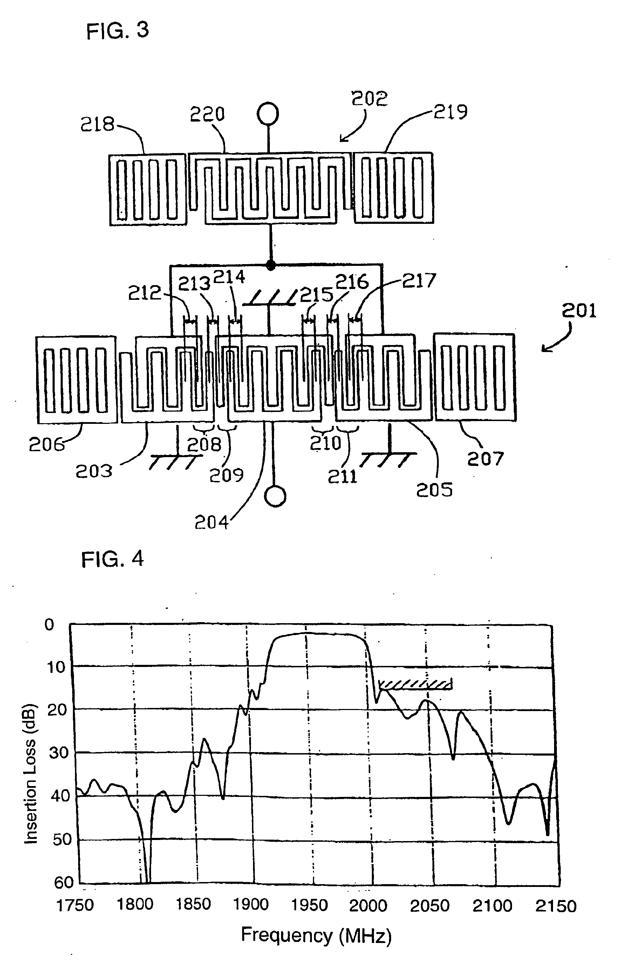

Fig. 2 shows the frequency characteristic given by the first embodiment of the present invention. Fig. 3 is a schematic plan view showing an example of the related art by way of comparison. Fig. 4 shows the frequency characteristic of the related art example shown in Fig. 3.

Referring to the configuration of the related art example shown in Fig. 3, a surface acoustic wave resonator 202 is connected in series with a longitudinal coupling resonator type surface acoustic wave filter 201 similarly to the first embodiment. The longitudinal coupling resonator type surface acoustic wave filter 201 comprises three IDTs 203, 204, and 205 and two reflectors 206 and 207, and small pitch electrode finger portions 208 to 211 are provided in the positions where the IDTs 203 and 204 and the IDTs 204 and 205 are adjacent to each other, respectively, similarly to the longitudinal coupling resonator type surface acoustic wave filter 101 of the first embodiment. The surface acoustic wave resonator 202 comprises one IDT 220 and two reflectors 218 and 219, similarly to the surface acoustic wave resonator 102 of the first embodiment.

The details of the design of the longitudinal coupling resonator type surface acoustic wave filter 201 of the related art example will be described below.
the meshing width W: 60.6 λI1
the number of electrode fingers in the IDT 203: 33 (the pitch of the four electrode fingers, arranged from the right-side end is decreased)
the number of electrode fingers in the IDT 204: 51 (the pitch of the four electrode fingers arranged from the right- and left-side ends, respectively, is decreased)
the number of electrode fingers in the IDT 205: 33 (the pitch of the four electrode fingers arranged from the left-side end is decreased)
the wavelength λI1 determined by the IDT: 2.06 µm
the wavelength λI2: 1.88 µm
the wavelength λR determined by the reflectors 206 and 207: 2.06 µm
the number of electrode fingers in the reflectors 206 and 207: 100
the intervals (212, 214, 215, 217 in Fig. 3) between the adjacent electrode fingers determining the wavelengths λI1 and λI2, respectively: 0.25 λI1 + 0.25 X12
the intervals (213, 216 in Fig. 3) between the IDTs 203 and 204 and the IDTs 204 and 205, that is, the intervals between the adjacent electrodes determining the wavelength λI2 in the IDTs 203 and 204 and between the adjacent electrodes determining the wavelength λI2 in the IDTs 204 and 205: 0.50 λI2
the intervals between the IDT 203 and 205 and the reflectors 206 and 207: 0.465 λR
the duty ratio (for the IDTs and the reflectors): 0.60
the film-thickness of the electrodes: 0.08 λI1

The details of the design of the surface acoustic wave resonator 202 of the related art example are as follows.
the meshing-width W: 49.1 λ
the number of electrode fingers in the IDT 220: 401
the wavelength λ (for the IDT 220 and the reflectors 218 and 219): 2.04 µm
the number of electrode fingers in the reflectors 218 and 219: 30
the intervals between the IDT 220 and the reflectors 218 and 219: 0.50 λ
the duty ratio (for the IDT 220 and the reflectors 218, 219: 0.60
the film-thickness of the electrodes: 0.08 λ

The comparison of Figs. 2 and 4 shows that the attenuation in the frequency range of 2010 MHz to 2070 MHz, which is on the higher frequency side of the pass band, in the first embodiment according to the present invention, is improved by about 5 dB compared with that of the related art example. The reason lies in that the transversal response in the first embodiment is reduced compared with that in the related art example.

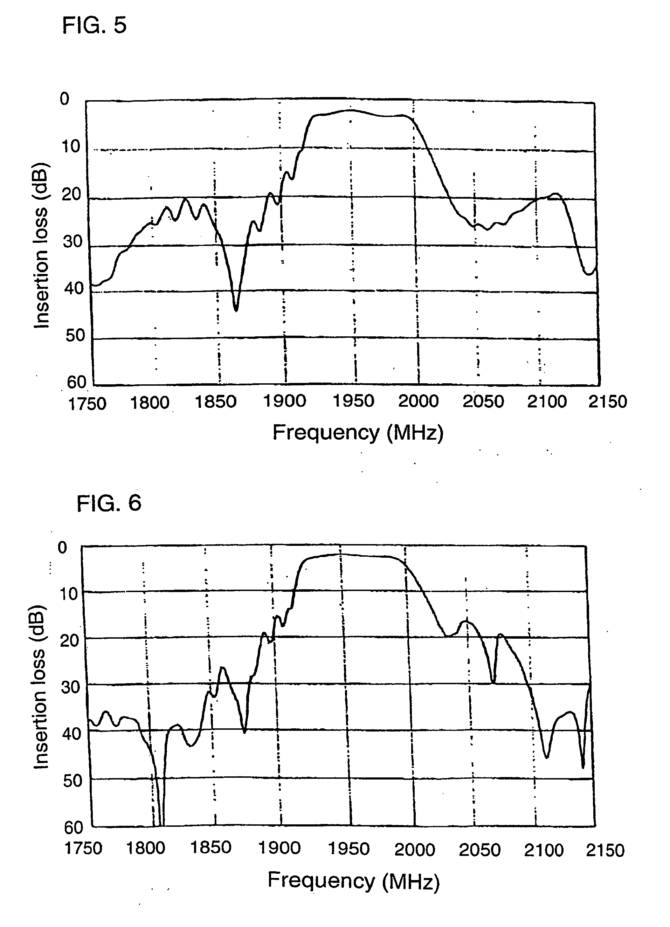

Fig. 5 shows the frequency characteristic given by the longitudinal coupling resonator type surface acoustic wave filter 101 of the first embodiment according to the present invention on its own, that is, without the surface acoustic wave resonator 102. Fig. 6 shows the frequency characteristic given by the longitudinal coupling resonator type surface acoustic wave filter 201 of the related art example on its own, that is without the surface acoustic wave resonator 202. The comparison of Figs. 5 and 6 shows that the transversal response caused by the longitudinal coupling resonator type surface acoustic wave filter 101 is reduced. Thus, it is seen that the effects of the present invention are obtained by the electrode-inversion in the small pitch electrode finger portions 108 and 109 of the longitudinal coupling resonator type surface acoustic wave filter 101.

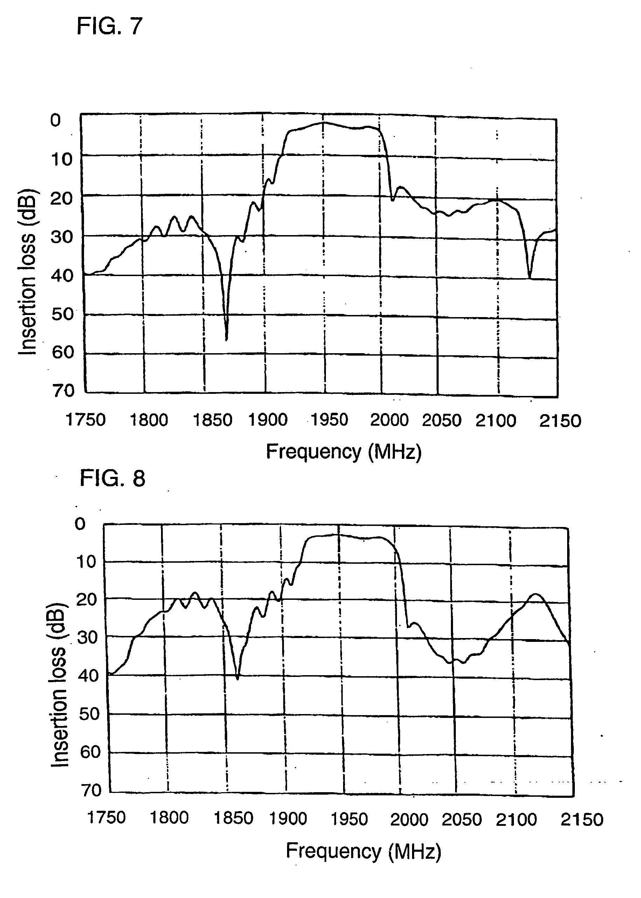

According to the first embodiment of the present invention, the position where the electrode inversion is carried out is provided substantially in the center of each small-pitch electrode finger portion by way of an example. Next, the frequency characteristics obtained when the position of the electrode inversion is changed from that of the first embodiment will be described. Fig. 7 shows the frequency characteristic obtained when the position for the electrode inversion is shifted toward the inner side of the filter compared with that of the first embodiment, specifically, when the polarities of the electrode fingers in the small pitch electrode finger portion 108 are arranged in the order from the left-hand side of +1, -1, +1, 0, -1, while those in the small pitch electrode finger portion 109 are arranged in the order from the left-hand side of +1, 0, -1, +1, -1. Fig. 8 shows the frequency characteristic obtained when the position for the electrode inversion is shifted toward the outer side of the filter compared with that of the first embodiment, specifically, when the polarities of the electrode fingers in the small pitch electrode finger portion 108 are arranged in the order from the left-hand side of +1, 0, -1, +1, -1, while those in the small pitch electrode finger portion 109 are arranged in the order from the left-hand side of +1, -1, +1, 0, -1.

Referring to Fig. 7, the level of the transversal response is deteriorated compared with that shown in Fig. 2. Referring to Fig. 8, the transversal response is reduced compared with that shown in Fig. 2. However, the level of the response near the frequency of about 2120 MHz is deteriorated, and moreover, the pass band width is decreased. As described above, even if the position for the electrode inversion is changed from that in the first embodiment, it is also effective in reducing the transversal response. However, from the standpoint of the wholly balanced electrical characteristics, it is preferable that the electrode inversion is carried out substantially in the center of each small pitch electrode finger portion as in the first embodiment.

As described above, according to the first embodiment of the present invention, a longitudinal coupling resonator type surface acoustic wave filter of which the transversal response is reduced compared with the longitudinal coupling resonator type surface acoustic wave filter of the related art can be obtained. In the first embodiment, the electrode inversion is carried out in the small pitch electrode finger portions of the middle IDT of the three IDTs. However, small pitch electrode finger portions may be provided in the IDTs on the right and left sides of the middle IDT, and the electrode inversion is carried out in the small pitch electrode finger portions, respectively. By this, the effects of the present invention can be also obtained.

In the first embodiment, the substrate made of 40±5° Y-cut X-propagation LiTaO₃ is used, but this is not restrictive. The same effects can be obtained when substrates made of a 64° to 72° Y-cut X-propagation LiNbO₃, 41° Y-cut X-propagation LiNbO₃, and so forth are employed. Moreover, in the above-described configuration of the first embodiment, the surface acoustic wave resonator is connected in series with the three IDTs longitudinal coupling resonator type surface acoustic wave filter. However, other configurations may be employed. For example, by using a two IDTs-containing configuration, an at least four IDTs-containing multi-electrode configuration, or a configuration in which the longitudinal coupling resonator type surface acoustic wave filters according to the present invention are connected in series in two stages, the same effects as those of the first embodiment can be obtained.

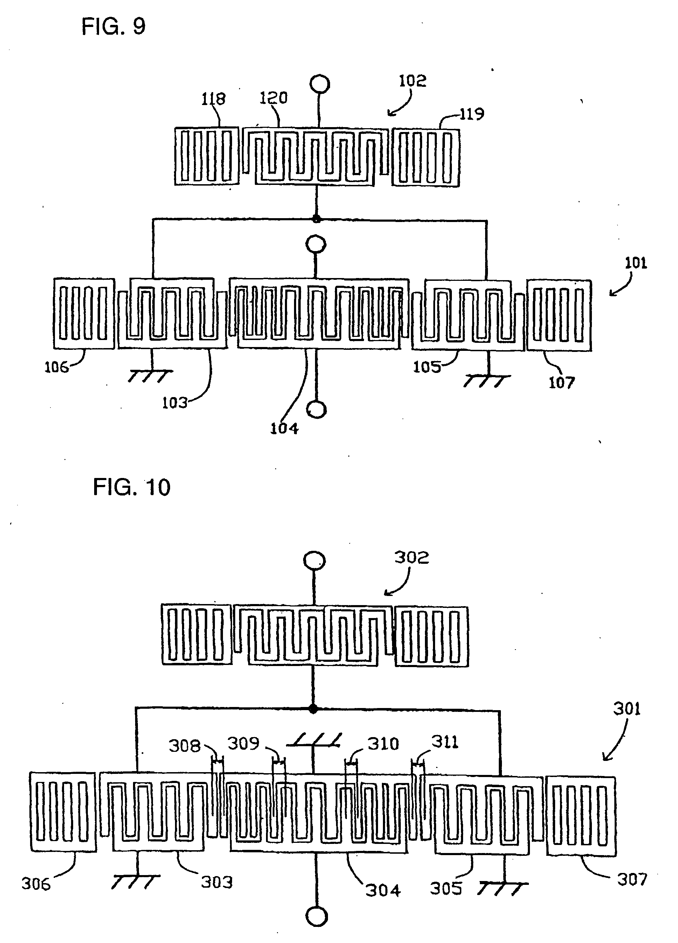

As shown in Fig. 9, a surface acoustic wave filter having an unbalanced-balanced conversion function may be provided by changing, in the configuration of Fig. 1, the ground terminal of the IDT in the center of the three IDTs to a signal terminal, and connecting the signal terminal to upper and lower bus bars for differential operation.

Next, the configuration of a second embodiment of the present invention will be described with reference to Fig. 10. Fig. 10 is a schematic plan view showing the configuration of the second embodiment of the present invention.

The second embodiment has the same configuration as the first embodiment according to the present invention except that the electrode inversion is carried out for IDTs 303 and 305 in contrast to the IDTs 103 and 105 of the first embodiment. Thereby, the polarities of the adjacent electrode fingers contained in the different IDTs, respectively, are made different.

The details of the design of the longitudinal coupling resonator type surface acoustic wave filter 301 are as follows. In the details, the wavelength determined by the pitch of the small pitch electrode fingers is designated by λI2, and that determined by the other electrode fingers is denoted by λI1.
the meshing-width W: 64.0 λI1
the number of electrode fingers in the IDT 303: 17
the number of electrode fingers in the IDT 304: 45 (the pitch of the six electrode fingers of these electrode fingers, which are arranged from each of the right- and left-side ends, is decreased)
the number of electrode fingers in the IDT 305: 17
the wavelength λI1 determined by the IDTs: 2.03 µm
the wavelength λI2: 1.85 µm
the wavelength λR determined by the reflectors 306 and 307: 2.06 µm
the number of electrode fingers in the reflectors 306 and 307: 100
the intervals 308 and 311 between the IDTs 303 and 304 and between the IDTs 304 and 305: 0.25 λI1 + 0.25 λI2
the intervals 309 and 310 between the adjacent electrode fingers determining the wavelengths λI1 and λI2 in the IDT 304: 0.25 λI1 + 0.25 λI2
the intervals between the IDTs 305, 303 and the reflectors 306, 307: 0.46 λR
the duty ratios of the IDTs and the reflectors: 0.60
the film-thickness of the electrode fingers: 0.08 λI1

Moreover, the details of the design of the surface acoustic wave resonator 302 are as follows.
the meshing-width W: 32.0 λ
the number of electrode fingers in the IDT: 401
the wavelengths λ (for the IDT and the reflectors): 2.03 µm
the number of electrode fingers in the reflectors: 30
the intervals between the IDT and the reflectors: 0.50 λ
the duty ratio of the IDT and the reflectors: 0.60
the film-thickness of the electrodes: 0.08 λ

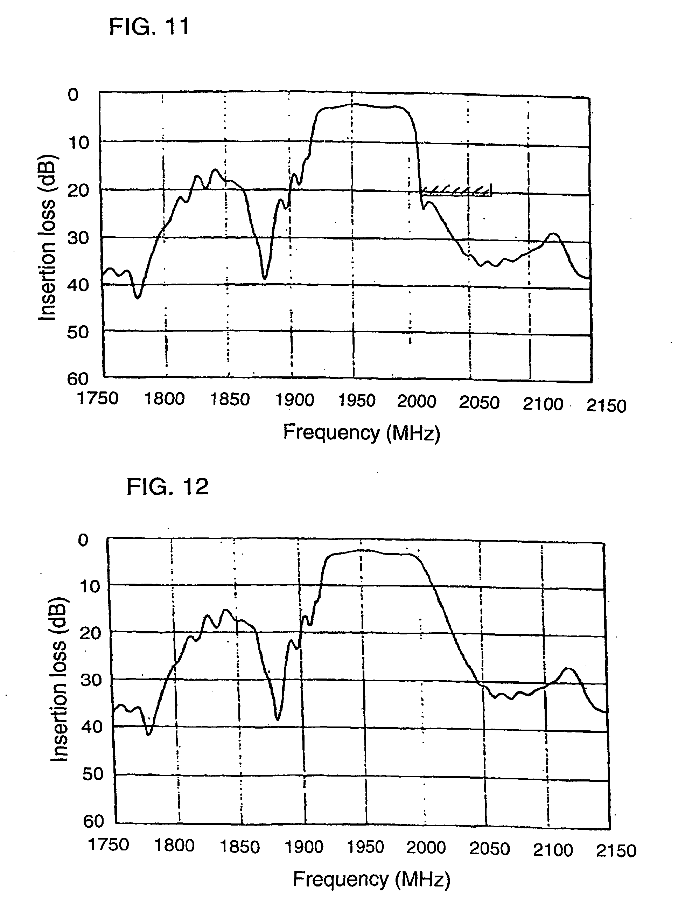

Fig. 11 shows the frequency characteristic given by the second embodiment according to the present invention. Moreover, Fig. 12 shows the frequency characteristic given by the longitudinal coupling resonator type surface acoustic wave filter 301 on its own.

According to the second embodiment of the present invention, the amount of attenuation on the higher frequency side of the pass band is more improved compared with that of the first embodiment. Especially, the amount of attenuation in the frequency range of at least 2070 MHz is improved by about 8 dB. Moreover, as seen in the frequency characteristic of Fig. 12 which is given by the longitudinal coupling resonator type surface acoustic wave filter 301 on its own, the transversal response is significantly improved compared with that of the first embodiment.

Thus, according to the second embodiment of the present invention, the polarities of the adjacent electrode fingers contained in the different IDTs, respectively, are made different, and thereby, the longitudinal coupling resonator type surface acoustic wave filter of which the transversal response is further improved compared with that of the first embodiment can be obtained.

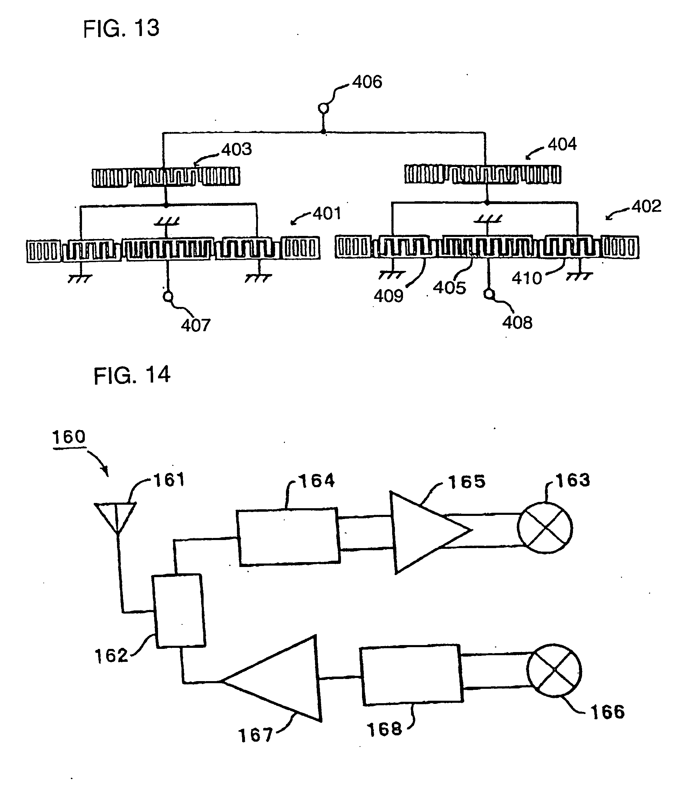

Hereinafter, the configuration of a third embodiment according to the present invention will be described with reference to Fig. 13. Fig. 13 is a schematic plan view showing the configuration of the third embodiment of the present invention.

In the third embodiment, two longitudinal coupling resonator type surface acoustic wave filters according to the first embodiment are connected in parallel to each other to form a surface acoustic wave device having an unbalanced-balanced conversion function with an input of 50Ω and an output of 200Ω. The details of the design parameters of the longitudinal coupling resonator type surface acoustic wave filters 401 and 402 and surface acoustic wave resonators 403 and 404 are the same as those of the surface acoustic wave filter of Fig. 1 except that the meshing width of each of the filters 401 and 402 and the resonators 403 and 404 is set to be half of the meshing-width in the surface acoustic wave device of the first embodiment, and the electrode inversion is carried out for IDT 405 of the longitudinal coupling resonator type surface acoustic wave filter 402. The electrode inversion of the IDT 405 of the longitudinal coupling resonator type surface acoustic wave filter 402 is carried out to reverse the phase by 180° with respect to an output signal from the longitudinal coupling resonator type surface acoustic wave filter 401. However, a method of reversing the phase by 180° is not limited to the above-described electrode inversion. As other methods, for example, it is suggestable that the electrode inversion is carried out for the IDTs 409 and 410, not for the IDT 405, the IDT 405 is divided into two parts without the electrode inversion being carried out, and balanced signals are output therefrom, and so forth. In Fig. 13, an unbalanced input terminal 406, and balanced output terminals 407 and 408 are shown.

In the third embodiment of the present invention shown in Fig. 13, the longitudinal coupling resonator type surface acoustic wave filters according to the present invention are connected in parallel to each other to form a surface acoustic wave device. By this, the surface acoustic wave device having a large attenuation on the higher frequency side of the pass band and having a balanced-unbalanced signal conversion function can be obtained.

The configuration of the surface acoustic wave device having a large amount of attenuation on the higher frequency side of the pass band and having a balanced-unbalanced signal conversion function is not limited to that of Fig. 13. Even if the surface acoustic wave device has another configuration by which a balanced-unbalanced signal conversion function can be attained, the same effects can be obtained by using the surface acoustic wave filters according to the present invention.

Fig. 14 is a schematic block diagram showing a communications device 160 using the longitudinal coupling resonator type surface acoustic wave filter and the surface acoustic wave device according to the present invention.

As shown in Fig. 14, a duplexer 162 is connected to an antenna 161. A longitudinal coupling resonator type surface acoustic wave filter 164 and an amplifier 165 are connected between the duplexer 162 and a reception-side mixer 163. Moreover, an amplifier 167 and a longitudinal coupling resonator type surface acoustic wave filter 168 are connected between the duplexer 162 and a transmission-side mixer 166. When the amplifier 165 corresponds to balanced signals as described above, the longitudinal coupling resonator type surface acoustic wave filter according to the present invention can be suitably used as the above-described longitudinal coupling resonator type surface acoustic wave filter 164.

Moreover, the surface acoustic wave device configured according to the present invention can be disposed instead of the longitudinal coupling resonator type surface acoustic wave filter 164. The surface acoustic wave device can be suitably used as well as the longitudinal coupling resonator type surface acoustic wave filter according to the present invention.

According to the present invention, a surface acoustic wave device of which the transversal response is reduced can be obtained, since electrode-inversion is carried out, that is, the polarities of two adjacent electrode fingers are made the same as described above. Moreover, when the position for the electrode inversion is set to be substantially the center of a small pitch electrode finger portion, the longitudinal coupling resonator type surface acoustic wave filter of which the pass band width is large and the transversal response is reduced can be obtained.

The electrode inversion is preferably carried out symmetrically with respect to the center of the surface acoustic wave filter, and thereby, the longitudinal coupling resonator type surface acoustic wave filter which eliminates a ripple from the pass band and has a reduced transversal response can be obtained.

Moreover, since the polarities of the adjacent electrode fingers contained in the neighboring IDTs, respectively, are preferably made different, the longitudinal coupling resonator type surface acoustic wave filter of which the transversal response is reduced in a still wider range can be obtained.

Preferably, the surface acoustic wave filter according to the present invention is applied for the longitudinal coupling resonator type surface acoustic wave device having a balanced-unbalanced signal conversion function. Thus, the surface acoustic wave device having the balanced-unbalanced signal conversion function of which the attenuation on the higher frequency side of the pass band is superior can be obtained.

A communications device having good communication qualities and high reliability can be obtained, since the device uses the longitudinal coupling resonator type surface acoustic wave filter or the surface acoustic wave device according to the present invention.

Further modifications and variations can be made in the detailed embodiments of the invention described above without departing from the scope of the present invention as defined in the accompanying claims.

## Claims

1. A longitudinal coupling resonator type surface acoustic wave filter (101) comprising
a piezoelectric substrate, and
at least two interdigital transducers (103-5) arranged on the piezoelectric substrate along the direction in which a surface acoustic wave is propagated,
at least one (104) of the interdigital transducers being provided with a small pitch electrode finger portion (108/109) in the end thereof which is adjacent to the other interdigital transducer (103/105), the small pitch electrode finger portion (108/109) having electrode fingers of which the pitch is smaller than that of the other electrode fingers in said at least one interdigital transducer,
**characterized in that** the small pitch electrode finger portion (108/109) includes, at a position substantially at the centre thereof, two adjacent electrode fingers (110,111/112,113) which are electrode-inverted such that the polarities of the two adjacent electrode fingers are made the same; and
there are not more than two such adjacent electrode fingers in the same small pitch electrode finger portion.

2. A longitudinal coupling resonator type surface acoustic wave filter (101) according to claim 1, wherein the electrode-inversion is carried out symmetrically with respect to the center of the surface acoustic wave filter.

3. A longitudinal coupling resonator type surface acoustic wave filter (301) according to claim 1, or 2, wherein the polarities of the adjacent electrode fingers in the adjacent interdigital transducers (303,304/304,305), respectively, are made different.

4. A surface acoustic wave device having a balanced-unbalanced conversion function, including the longitudinal coupling resonator type surface acoustic wave filter according to any one of claims 1 to 3.

5. A communications device including the longitudinal coupling resonator type surface acoustic wave filter according to any one of claims 1 to 3, or the surface acoustic wave device according to claim 4.

## Patentansprüche

1. Ein Longitudinalkopplungsresonatortyp-Oberflächenwellenfilter (101), das folgende Merkmale aufweist:
ein piezoelektrisches Substrat, und
zumindest zwei Interdigitalwandler (103-5), die auf dem piezoelektrischen Substrat entlang der Richtung, in der sich eine akustische Oberflächenwelle ausbreitet, angeordnet sind,
wobei zumindest einer (104) der Interdigitalwandler mit einem Elektrodenfingerabschnitt mit kleiner Teilung (108/109) in dem Ende desselben, das benachbart zu dem anderen Interdigitalwandler (103/105) ist, versehen ist, wobei der Elektrodenfingerabschnitt mit kleiner Teilung (108/109) Elektrodenfinger aufweist, deren Teilung kleiner ist als diejenige der anderen Elektrodenfinger in dem zumindest einen Interdigitalwandler,
**dadurch gekennzeichnet, dass** der Elektrodenfingerabshmitt mit kleiner Teilung (108/109) an einer Position im Wesentlichen in der Mitte desselben zwei benachbarte Elektrodenfinger (110, 111/112, 113) umfasst, die elektrodeninvertiert sind, so dass die Polaritäten der beiden benachbarten Elektrodenfinger gleich gemacht sind; und
es nicht mehr als zwei derartige benachbarte Elekrodenfinger in dem gleichen Elektrodenfingerabschnitt mit kleiner Teilung gibt.

2. Ein Longitudinalkopplungsresonatortyp-Oberflächenwellenfilter (101) gemäß Anspruch 1, bei dem die Elektrodeninversion symmetrisch in Bezug auf die Mitte des Obertlächenwellenfilters ausgeführt ist.

3. Ein Longitudinalkopplungsresonatortyp-Oberflächenwellenfilter (301) gemäß Anspruch 1 oder 2, bei dem die Polaritäten der benachbarten Elektrodenfinger in den jeweiligen benachbarten Interdigitalwandlern (303, 304/304, 305) unterschiedlich gemacht sind.

4. Ein Oberflächenwellenbauelement mit einer Symmetrisch-Unsynmetrisch-Umwandlungsfunktion, das das Longitudinalkopplungsresonatortyp-Oberflächenwellenfilter gemäß einem der Ansprüche 1 bis 3 umfasst.

5. Eine Kommunikationsvorrichtung, die das Longitudinalkopplungsresonatortyp-Oberflächenwellenfilter gemäß einem der Ansprüche 1 bis 3 oder das Oberflächenwellenbauelement gemäß Anspruch 4 umfasst.

## Revendications

1. Filtre à ondes acoustiques de surface du type à résonateur de couplage longitudinal (101) comportant
un substrat piézo-électrique, et
au moins deux transducteurs interdigités (103-5) disposés sur le substrat piézo-électrique selon la direction dans laquelle est propagée une onde acoustique de surface,
au moins l'un (104) des transducteurs interdigités étant muni d'une partie de doigt d'électrode de petit pas (108/109) à son extrémité qui est adjacente à l'autre transducteur interdigité (103/105), la partie de doigt d'électrode de petit pas (108/109) possédant des doigts d'électrode dont le pas est inférieur à celui des autres doigts d'électrodes dans ledit au moins premier transducteur interdigité,
**caractérisé en ce que** la partie de doigt d'électrode de petit pas (108/109) comprend, en une position sensiblement au centre de celle-ci, deux doigts d'électrode adjacents (110, 111/112, 113) qui ont des électrodes inversées de sorte que les polarités de deux doigts d'électrode adjacents sont les mêmes ; et
il n'y a pas plus de deux doigts d'électrode adjacents dans la même partie de doigts d'électrode de petit pas.

2. Filtre à ondes acoustiques de surface du type à résonateur de couplage longitudinal (101) selon la revendication 1, dans lequel l'inversion d'électrodes est effectuée symétriquement par rapport au centre du filtre à ondes acoustiques de surface.

3. Filtre à ondes acoustiques de surface du type à résonateur de couplage longitudinal (301) selon la revendication 1 ou 2, dans lequel les polarités des doigts d'électrode adjacents dans les transducteurs interdigités adjacents (303, 304/304, 305), respectivement, sont différentes.

4. Dispositif à ondes acoustiques de surfaces possédant une fonction de conversion équilibrée-déséquilibrée, comprenant le filtre à ondes acoustiques de surface de type à résonateur de couplage longitudinal selon l'une quelconque des revendications 1 à 3.

5. Dispositif de communication comprenant le filtre à ondes acoustiques de surface du type à résonateur de couplage longitudinal selon l'une quelconque des revendications 1 à 3, ou le dispositif à ondes acoustiques de surface selon la revendication 4.
